# EUROPEAN PATENT SPECIFICATION

(11) **EP 2 450 621 B1**
(45) Date of publication and mention of the grant of the patent: **10.12.2014**
(21) Application number: 09846811.9
(22) Date of filing: 30.06.2009
(51) Int. Cl.: F21S 8/08, F21S 9/03, F21V 11/18, F21Y 105/00, F21V 14/00, H01L 27/30, G02F 1/13

(54) **ILLUMINATING APPARATUS**
BELEUCHTUNGSGERÄT
APPAREIL D'ÉCLAIRAGE

(43) Date of publication of application: 09.05.2012
(73) Proprietor: Panasonic Corporation, Osaka 571-8501 (JP)
(72) Inventor: SUMIYAMA, Shigetsugu, Osaka 540-6207 (JP)
(74) Representative: Müller-Boré & Partner Patentanwälte PartG mbB
(86) International application number: PCT/JP2009/062014
(87) International publication number: WO 2011/001518

(56) References cited:
- EP-A1- 2 098 674
- EP-A2- 1 187 213
- WO-A1-2005/045793
- WO-A1-2007/107903
- WO-A2-2004/016897
- DE-A1-102005 057 699
- JP-A- 9 265 856
- JP-A- 2003 346 529
- JP-A- 2005 203 239
- JP-A- 2006 107 861
- JP-A- 2007 005 227

## Description

### Technical Field

The present invention relates to an illuminating apparatus, and more particularly to a surface emission type illuminating apparatus that generates an electric power through a solar cell with sunlight during the daytime, and lightens a surface-emitting module by its electromotive force.

### Background Art

Up to now, as a method of illuminating a wall surface, illumination using a projector is mainstream, but in recent years, attention has been paid to a surface emission type self-emitting illuminating apparatus as an illuminating apparatus that facilitates installation without requiring a feed equipment. The surface emission type self-emitting illuminating apparatus generates the electric power through the solar cell with the use of sunlight, and lightens the surface-emitting module by the electromotive force. Since the surface emission type self-emitting illuminating apparatus requires no power wiring, and is suitable for outdoor use such as a ground surface or a wall surface of a fence, attention is paid to the surface emission type self-emitting illuminating apparatus as an illuminating apparatus high in energy saving performance based on natural energy.

The self-emitting illuminating apparatus of this type requires a control under which when there is sunlight in the daytime, the surface-emitting module is not lightened, and the electric power is generated by the solar cell whereas in the dark, the surface-emitting module is lightened. The self-emitting illuminating apparatus employs a method in which the illuminance is detected by the aid of an illuminance sensor, and energization is switched between the solar cell and the surface-emitting module according to the detection result.

For example, there has been proposed a complex illuminating apparatus in which a power generation element is disposed on a light-transmissive substrate other than an area where an electroluminescence element is formed (Patent Document 1). In this apparatus, a sensor is disposed in a portion where the illumination element is disposed, and brightening or darkening of the electroluminescence element is controlled on the basis of the sensor.

Also, there has been proposed a display panel in which a pulse light source and a liquid crystal shutter are laminated on each other, and the light is selectively distributed according to the drive of the liquid crystal shutter (Patent Document 2).

Furthermore, there have been proposed a surface-emitting panel for illumination, and an illuminating apparatus, which can be detachably attached to a frame (Patent Document 3).

Document WO 2007/107903 A1 discloses a colour tuneable lighting device comprising at least one tuneable optical component capable of controlling the optical appearance of a lighting device. An LED may be provided that may emit white light. The tuneable optical component can be electrically controlled so as to change the spectrum of the white light emitted by the LED.

Document DE 10 2005 057 699 A1 discloses a self luminous device comprising a layer structure having a transparent sealing layer, a transparent filling compound, a third transparent cathode, a third transparent luminous layer, a third transparent anode, a second transparent insulating layer, a second transparent cathode, a second transparent luminous layer, a second transparent anode, a first transparent insulating layer, a first transparent cathode, a first transparent luminous layer, first transparent anode, a non-transparent layer, an anode terminal, a transparent basis layer, a transparent insulating layer, a transparent anode of the solar cell, a thin layer solar cell, a transparent cathode of the solar cell, and a transparent sealing layer.

Document JP 2005 203 239 A discloses a light emitting device provided with an electroluminescent element and a power generating element of the compound light emitting device comprises an organic electroluminescent element formed on a transparent substrate, wherein the power generating element, which is capable to convert the light emitted from the outside and the organic electroluminescent element, is formed at the part except for the place wherein the organic electroluminescent element on the transparent substrate is formed.

### Related Art Documents

### Patent Documents

Patent Document 1: JP-A-2005-203239
Patent Document 2: JP-A-09-265856
Patent Document 3: JP-A-2007-005227

### Summary of the Invention

### Problem to be Solved by the Invention

As described above, there have been variously proposed complex elements each having the light emitting element and a power generation device such as the solar cell. However, in the display panel of Patent Document 2, on/off selection of light is merely conducted by driving the liquid crystal shutter, and the liquid crystal shutter is disposed on a front surface of the light emitting element to conduct the operation of switching the light from the light emitting element.

Also, in Patent Document 1, the solar cell is disposed on the light-transmissive substrate in the area except for the area in which the electroluminescence element is formed. The illumination sensor is disposed on a portion where the solar cell is disposed. Lighting is conducted only when necessary according to the detection result of the illumination sensor under the control, for the purpose of pursuing an energy saving performance.

However, at the time of lightening the electroluminescence element, the light into the power generation element on a back surface cannot be blocked, and the light is substantially emitted from both surfaces. This results in such a problem that the illumination efficiency is not sufficiently obtained.

On the other hand, when the illuminating apparatus is used for street lights, it is desirable that the illuminating apparatus is made transparent during an off-state, and an overall laminated body is transparent so that the light is prevented from being blocked.

The present invention has been made in view of the above viewpoints, and an object thereof is to provide an illuminating apparatus that is high in illumination efficiency and excellent in exteriority.

This problem is solved by an illuminating apparatus having the features disclosed in claim 1. Preferred embodiments are defined in the dependent claims.

### Means for Solving the Problem

An illuminating apparatus according to the present invention includes: a light-transmissive surface-emitting module; and a switching board that is disposed on a back surface of the surface-emitting module, wherein the switching board is configured such that a state of the switching board can be switched between a light blocking state and a light transmitting state.

With this configuration, the switching board is configured such that the state of the switching board can be switched between the light blocking state and the light transmitting state. Therefore, when the surface-emitting module emits a light, the state of the switching board is switched to the light blocking state whereby the light can be guided in one direction, and the irradiation efficiency can be prevented from being deteriorated. On the other hand, when the surface-emitting module turns off the light, the surface-emitting module is made light-transmissive, as a result of which there can be provided the illuminating apparatus that prevents the light from being blocked by the illuminating apparatus per se, and causes no feeling of pressure at the time of turning off the light. Also, an unnecessary portion can be shut out at the time of turning on the light to improve the exteriority.

The above illuminating apparatus further includes a solar cell that is arranged on the back surface of the surface-emitting module through the switching board.

With this configuration, a function of generating the electric power in a state where the exterior at the time of turning off the light is maintained can be added.

Also, according to the present invention, in the above illuminating apparatus, the switching board includes a liquid crystal shutter panel.

With this configuration, the switching board can be easily switched between a transparent state and a nontransparent state by application of a voltage.

Also, according to the present invention, in the above illuminating apparatus, the switching board includes a reflection board detachably attached thereto.

With this configuration, the switching between the transparent state and the non-transparent state can be easily conducted with mechanical attachment or detachment of the switching board. When the solar cell is laminated, the switching board may be disposed between the solar cell and the surface-emitting module so as to be inserted or removed in parallel to a light emitting surface. Also, a back surface of the solar cell, that is, the surface-emitting module, the solar cell, and the switching board may be disposed in the stated order. The switching board may be so disposed as to be movable in parallel to the light emitting surface. Also, when the switching board is disposed on the outermost layer, the switching board may be hinge-coupled thereto in an openable/closable manner.

Also, according to the present invention, the above illuminating apparatus further includes an illumination sensor, and a lighting control unit configured to control lighting of the surface-emitting module according to an output of the illumination sensor.

With this configuration, the lighting control can be automatically conducted, and the power consumption can be saved.

Also, according to the present invention, in the above illuminating apparatus, the illumination sensor is disposed in parallel to a frame part (edge part) that surrounds a light emitting unit of the surface-emitting module from a side, a storage battery is disposed at a back side of the solar cell, and configured to accumulate an electromotive force generated by the solar cell, and the lighting control unit controls the lighting of the surface-emitting module with application of a voltage from the storage battery.

With this configuration, while the storage battery is charged by the transparent solar cell in the daytime, the light is allowed to be transmitted without being blocked so that a part of sunlight contributes to electric power generation by the solar cell, and the remaining sunlight passes through the panel. Accordingly, because the surface-emitting module looks transparent even in a storage state, the illuminating apparatus (panel per se) is hardly visible. Also, at night, the surface-emitting module emits the light with the electric power from the storage battery. However, because a liquid crystal shutter forms a mirror surface with the electric power from the storage battery, the light from the surface-emitting module is efficiently led only to one side.

Also, according to the present invention, in the above illuminating apparatus, the surface-emitting module includes an electroluminescence element in which a light-transmissive first electrode, a layer having a light emitting function, and a light-transmissive second electrode are sequentially laminated on a light-transmissive substrate.

With this configuration, the surface-emitting module that is thin and simple in structure can be provided.

Also, according to the present invention, in the above illuminating apparatus, the solar cell and one electrode of the liquid crystal shutter, and the other electrode of the liquid crystal shutter and one electrode of the electroluminescence element may be integrated together, respectively.

With this configuration, the illuminating apparatus can be more thinned.

### Advantages of the Invention

As has been described above, according to the illuminating apparatus of the present invention, there can be provided the illuminating apparatus excellent in the exterior and high in irradiation efficiency. Also, even when a large-area panel is configured, the panel is made light-transmissive at the time of turning off the light, resulting in the illuminating apparatus that prevents the light from being blocked by the illuminating apparatus per se, and causes no feeling of pressure at the time of turning off the light.

### Brief Description of the Drawings

FIG. 1 is an external view illustrating an illuminating apparatus according to a first embodiment of the present invention.
FIGS. 2(a) and 2(b) are diagram illustrating an illuminating apparatus according to the first embodiment of the present invention, in which FIG. 2(a) is a top view thereof, and FIG. 2(b) is a cross-sectional view thereof.
FIG. 3 is a cross-sectional view illustrating one state of the illuminating apparatus according to the first embodiment of the present invention.
FIG. 4 is a cross-sectional view illustrating another state of the illuminating apparatus according to the first embodiment of the present invention.
FIG. 5 is a perspective view illustrating the illuminating apparatus according to the first embodiment of the present invention.
FIG. 6 is a diagram illustrating an illumination sensor and an installation part thereof in the illuminating apparatus according to the first embodiment of the present invention.
FIG. 7 is a schematically cross-sectional view of a main portion of the illuminating apparatus according to the first embodiment of the present invention.
FIG. 8 is an external view illustrating an illuminating apparatus according to a second embodiment of the present invention.
FIG. 9 is a schematically cross-sectional view of a main portion of the illuminating apparatus according to the second embodiment of the present invention.
FIG. 10 is a schematically cross-sectional view of a main portion of an illuminating apparatus according to a third embodiment of the present invention.

### Mode for Carrying Out the invention

Hereinafter, embodiments of the present invention will be described in detail with reference to drawings.

### (First Embodiment)

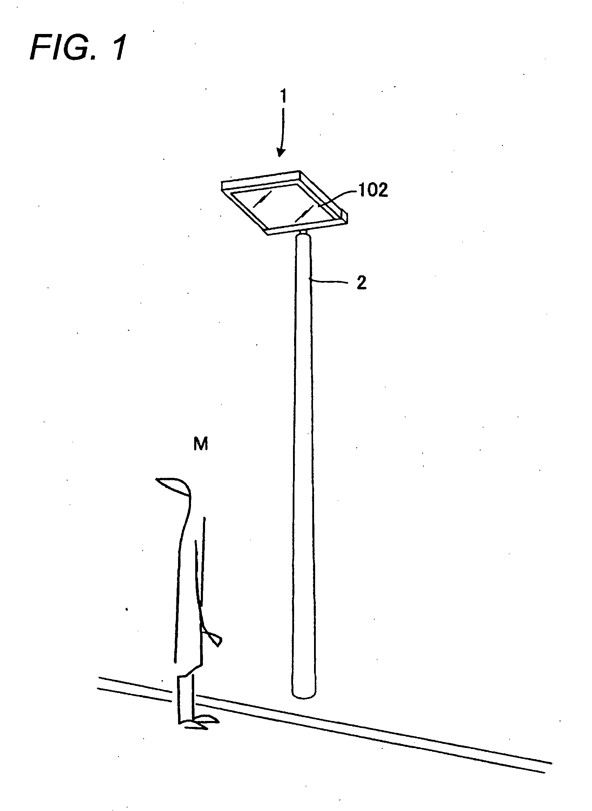

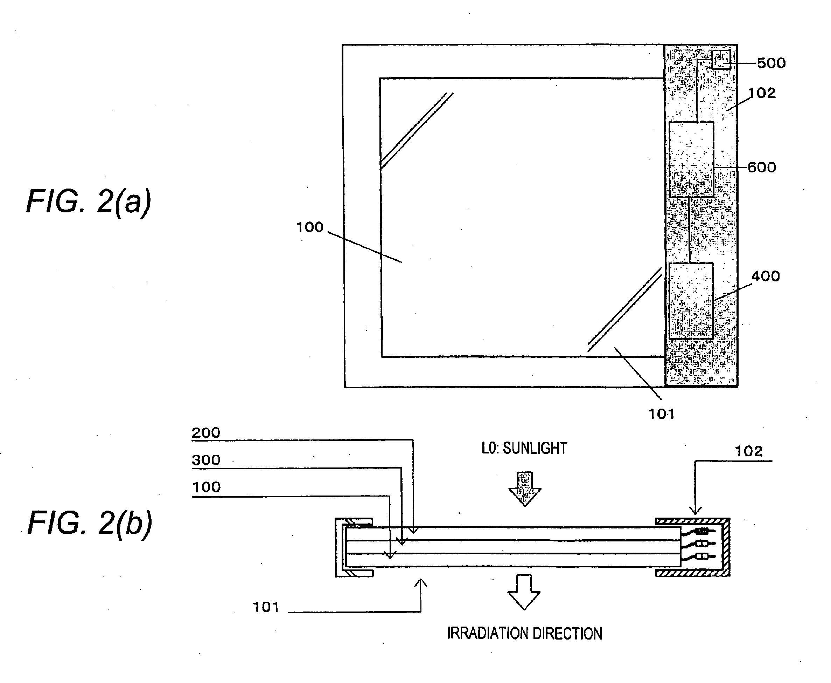

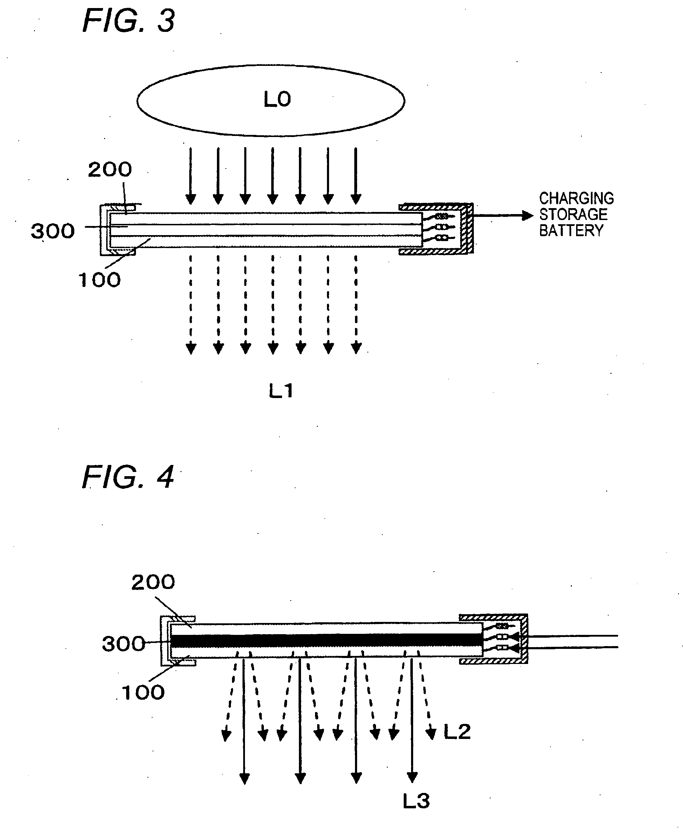

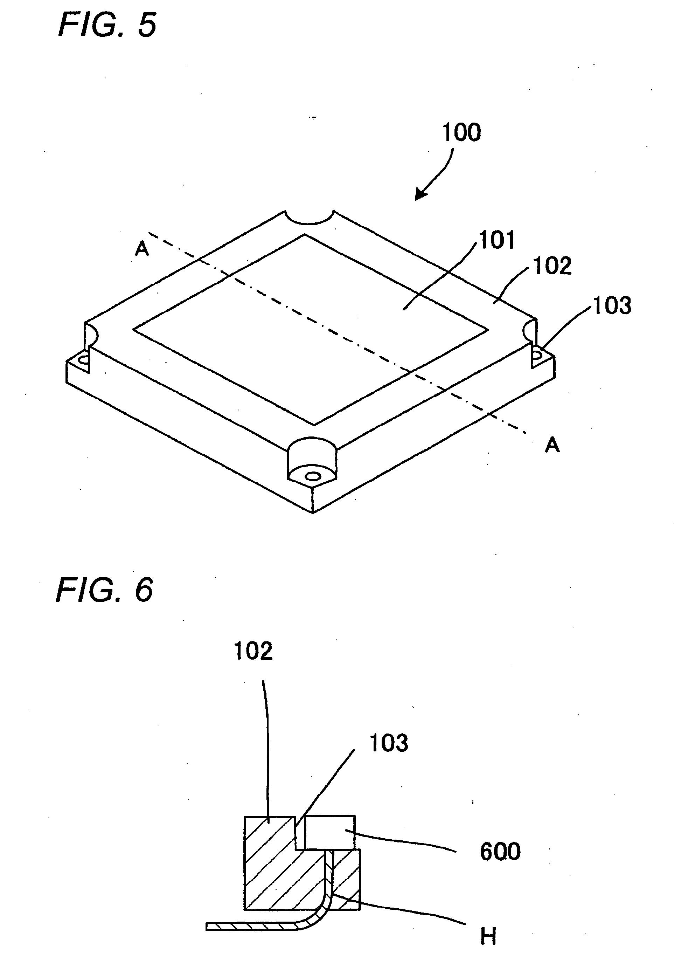

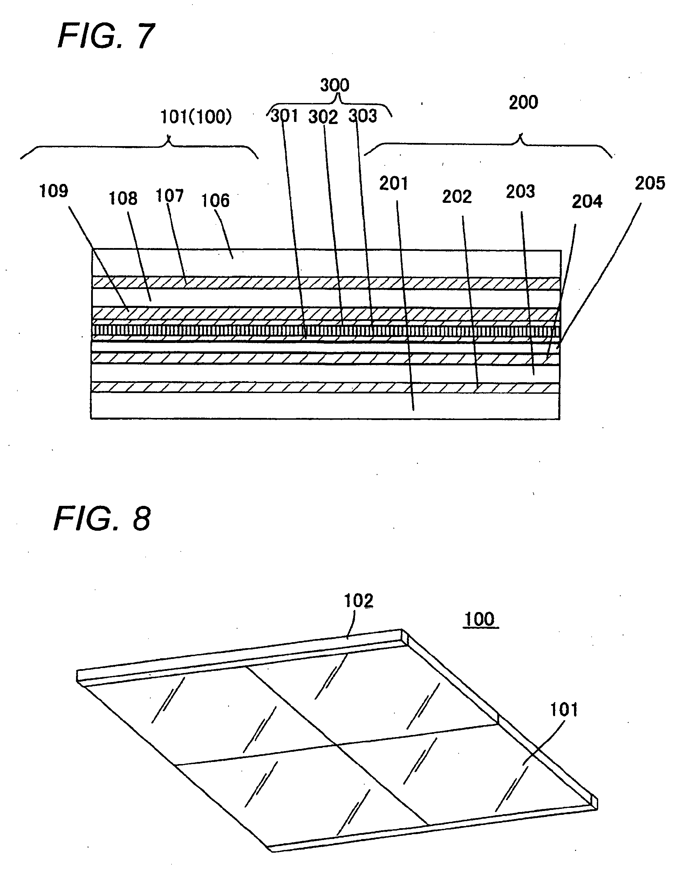

An illuminating apparatus 1 according to a first embodiment of the present invention is fitted to a pole placed on a road. FIG. 1 is an external view, FIGS. 2(a) and 2(b) are a top view and a cross-sectional illustrative view, respectively, FIGS. 3 and 4 are cross-sectional views of the apparatus illustrating the operation, FIG. 5 is a schematic perspective view, FIG. 6 is an enlarged view of the main portion of the illustration sensor unit, and FIG. 7 is an enlarged cross-sectional view of a main portion of the illuminating apparatus. The illuminating apparatus is equipped with a light-transmissive surface-emitting module 100, and a solar cell 200 disposed over a back surface of the surface-emitting module 100 through a switching board formed of a liquid crystal shutter panel 300. When there is sunlight, the solar cell 200 transmits the sunlight while generating an electric power as a solar cell. When there is no sunlight, the liquid crystal shutter panel 300 is put into a light blocking state so that the light is led to only the front of the surface-emitting module 100.

FIGS. 2 to 4 correspond to an A-A cross section of FIG. 5. As illustrated in FIGS. 2(a) and 2(b), the illuminating apparatus includes a surface-emitting module 100 formed of a light-transmissive organic electroluminescence element, a solar cell 200 disposed over the back surface of the surface-emitting module 100 through the liquid crystal shutter panel (switching board) 300, and an illumination sensor 500 disposed in parallel to a frame part 102 surrounding a light emitting unit 101 of the surface-emitting module 100 from a side. The illuminating apparatus also includes a storage battery 400 disposed on a back surface side of the solar cell 200, and accumulating an electromotive force generated by the solar cell 200 therein, and a control unit 600 configuring a lighting control unit that controls the lighting of the surface-emitting module while applying a voltage from the storage battery 400 according to an output of the illumination sensor 500. This illuminating apparatus is sealed by a vessel (not shown) and an outer cover (not shown), and arranged outdoor. FIG. 6 is an enlarged diagram of a main portion of the illumination sensor and an installation part thereof.

The organic electroluminescence element configuring the light emitting unit 101 of the surface-emitting module easily provides translucency by selection of the light emitting material. As illustrated in a schematic cross-sectional view of FIG. 7, a light emitting function layer 108 including a hole transport layer made of an aromatic diamine compound such as α-NPD, a light emitting layer made of Alq3, and an electron transport layer made of coumarin, and a second electrode 109 having an ITO pattern about 100 to 200 nm in thickness are sequentially formed on a first electrode 107 having an ITO pattern about 100 to 200 nm in thickness, which is formed on a light-transmissive glass substrate 106 through a sputtering method, thereby configuring the light-transmissive organic electroluminescence element. A frame part 102 made of aluminum cast is so disposed as to surround a peripheral edge of the glass substrate.

Notch parts 103 are formed at outer sides of the frame part 102, and the illumination sensor 500 formed of a CdS pyroelectric element is disposed in any one of the notch parts 103 to detect the illuminance of the external. Aluminum cast is exposed from each surface of the notch parts 103 to configure a reflective surface.

Also, the solar cell 200 is of a size falling within a projected area of the light emitting unit 101, and arranged at a given distance from the light emitting unit 101 of the surface-emitting module 100. The solar cell is configured by a laminated body including a light-transmissive fourth electrode 202 such as ITO which is formed on a light-transmissive support substrate 201, a polycrystal silicon layer 203 as a photoelectric conversion element layer, a light-transmissive third electrode 204 mainly containing ITO which is about 100 to 200 nm in thickness, and an antireflective film 205. The light-transmissive third electrode 204 made of ITO is disposed at a side facing the light emitting unit 101 of the surface-emitting module 100. The solar cell needs a size corresponding to an electric energy required for a light source. However, because the organic electroluminescence element is of a power saving property, the solar cell is sufficient to provide the same light receiving area as an effective region of the organic electroluminescence element, that is, a light emitting region. The solar cell can be downsized with the laminated structure. Also, the antireflective film that covers the surface of the third electrode which is the light receiving surface side is adjusted as occasion demands to provide a so-called color solar cell which can have a desired color, and whose surface is shiny.

That is, the conventional solar cell is navy or purple whereas the color solar cell freely changes an apparent color by changing the thickness or refractive index of the antireflective film of the solar cell (using the light interference effect of the thin film), and provides various colors. In this way, with adjustment of the composition, quality, or thickness of the antireflective film of the color solar cell, there can be adjusted a ratio at which the light is reflected from the organic electroluminescence element and led to the front surface thereof, and a ratio at which the light that contributes to the power generation in the solar cell is taken in.

Also, the liquid crystal shutter panel 300 is configured so that a liquid crystal layer 303 is disposed between two electrodes 301 and 302, and a liquid crystal shutter is opened or closed by a voltage applied between the electrodes 301 and 302.

Also, the illumination sensor 500 is formed of the CdS pyroelectric element, and configured to detect an outside light. As illustrated in the enlarged diagram of the main portion in FIG. 6, the illumination sensor 500 is fitted to any one of the notch parts 103 provided on the frame part 102 of the surface-emitting module 100.

Further, the storage battery 400 is provided to accumulate the electromotive force of the solar cell 200, and feed the electromotive force to the surface-emitting module 100 as occasion demands. The organic electroluminescence element can be downsized because of the power saving property, and can be also applied to a downsized electronic device such as a cellular phone.

Also, the control unit 600 is equipped with a system LSI configured to control the power supply to the organic electroluminescence element in the surface-emitting module 100, and control blinking on the basis of an output of the illumination sensor 500, with the storage battery 400 as a power supply. The control unit 600 is connected to the illumination sensor 500, the storage battery 400, the liquid crystal shutter panel 300, the surface-emitting module 100, and the solar cell 200, and controls the drive of the units. In this example, in the daytime, the control unit 600 controls the organic electroluminescence element to turn off the light, and the electromotive force generated by the solar cell 200 to be led to the storage battery 400 for charging. At night, the control unit 600 controls the organic electroluminescence element to turn on the light. The control unit 600 not only controls the on/off operation of the organic electroluminescence element and the liquid crystal shutter panel 300, but also controls the applied voltage to the organic electroluminescence element and the liquid crystal shutter panel 300 so as to control the luminance according to the brightness. Also, a timer function is added to a feeding part that feeds the electric power to the organic electroluminescence element whereby energy saving can be also realized by dimming the light at midnight. Also, when the organic electroluminescence element emits the light, the light is slightly leaked to the solar cell. The electromotive force is slightly generated even by this light to enable the power generation.

Also, the storage battery 400 and the control unit 600 are stored in the frame part 102. However, when the storage battery 400 and the control unit 600 cannot be stored therein, those units may be stored within the pole.

Although being not shown, it is desirable that the outside of the illuminating apparatus is coated with an outer cover. With this configuration, the outer cover is made of glass or a high-strength resin such as a polycarbonate resin or acrylic resin, which protects the built-in parts from an external impact and has the translucency. A surface of the outer cover is coated with a photocatalytic membrane to enable the prevention of contamination. If an anti-insect coating called "Insect Veil coating" is used together, insects can be prevented from getting near the illuminating apparatus to look unsightly. Also, a mounting hole may be formed in the outer cover so that the outer cover can be fitted to an outer wall surface.

Subsequently, the operation of the illuminating apparatus will be described.

During the daytime, the liquid crystal shutter panel is driven through the control unit 600 according to the luminance detected by the illumination sensor 500. In this situation, the control unit applies no voltage to the two electrodes of the liquid crystal shutter panel 300, and the liquid crystal layer 303 is in a light transmitting state. As illustrated in FIG. 3, the electric power is generated by the transparent solar cell 200 with a sunlight L0, and the storage battery 400 is charged by the electromotive force of the solar cell. Then, a part of the sunlight L0 goes through the solar cell 200 and the liquid crystal shutter panel 300, goes through the surface-emitting module, and falls onto a person walking on a road. L1 is a transmitted light.

At night, a voltage is applied to the two electrodes of the liquid crystal shutter panel 300 through the control unit 600 according to the illumination detected by the illumination sensor 500, and the liquid crystal layer 303 becomes in the light blocking state. As illustrated in FIG. 4, in the surface-emitting module, a voltage is applied between the electrodes by the control unit 600, and the light emitting layer emits a light. In this situation, because the liquid crystal layer 303 of the liquid crystal shutter panel 300 is in the light blocking state, the light of the surface-emitting module that is the organic electroluminescence element is blocked by the liquid crystal shutter panel, and extracted to only a front surface side, and the light from the organic electroluminescence element falls onto the person walking on the road. L2 is a reflective light reflected by the liquid crystal panel, and L3 is a direct light toward an irradiation direction.

With this configuration, there can be provided the self-emitting illuminating apparatus that is downsized, thinned, excellent in the light emitting efficiency, and few in erroneous lighting.

The surface-emitting module is configured by the organic electroluminescence element in which the layer having a light emitting function is held between the light-transmissive first and second electrodes. Therefore, the power generation with a high efficiency can be realized while the attenuation of the amount of light into the solar cell on the back surface is suppressed.

Also, the illumination sensor is disposed on the notch part disposed on the frame part of the light-emitting module. Therefore, the light reflected by the front surface of the solar cell and the light of the organic electroluminescence element per se that is the light emitting element can be blocked, and only the outside light can be efficiently detected without any disturbance.

Also, because the frame part is configured by a frame body of aluminum cast, the notch part configures the light blocking surface, and the light from the surface-emitting module can be surely blocked.

The frame part is not limited to aluminum, but may be made of resin. If the frame part is not made of a light shielding material, a light blocking film or a reflective film may be formed on the notch part.

Also, the self-emitting illuminating apparatus according to the present invention has an air-tight case in which the vessel and the outer cover are air-tightly sealed with a sealing resin. Therefore, there is provided the illuminating apparatus high in durability even when the illuminating apparatus is embedded in a ground surface or used outside.

In the above first embodiment, the surface-emitting module and the solar cell may be supported within the vessel, or the surface-emitting module 100, the liquid crystal shutter panel 300, and the solar cell 200 may be bonded together with a light-transmissive adhesive resin.

The illumination sensor can be applied with various photosensors such as a silicon photodiode, a phototransistor, or a GaAsP photodiode in addition to the above CdS pyroelectric element, according to the usage environmental conditions. Those photodiodes can be employed to measure the illuminance.

The illumination sensor may be integrated with a process circuit using a thin film transistor by forming a sensor unit using an amorphous silicon thin film on a substrate on which the organic electroluminescence element is formed.

Also, in the above embodiment, the organic electroluminescence element formed on the glass substrate through an evaporation method is described. However, without limited to this configuration, as the substrate, there can be used a resin substrate such as a polymer film made of polyethylene terephthalate, polycarbonate, polymethylmethacrylate, polyethersulfone, polyvinyl fluoride, polypropylene, polyethylene, polyacrylate, amorphous polyolefin, or fluorine resin. Also, a flexible resin substrate may be used.

Furthermore, with the use of a polymer light-emitting material, a layer having the light emitting function can be formed on the resin substrate through a printing method. As the polymer light emitting material, there can be applied various organic compounds such as polyfluorene compound, polystyrene compound, polycarbonate compound, or acrylic compound. Also, various buffer layers can be interposed between the electrode and the layer having the light emitting function as occasion demands.

The entire process can be realized through the printing method depending on material selection.

### (Second Embodiment)

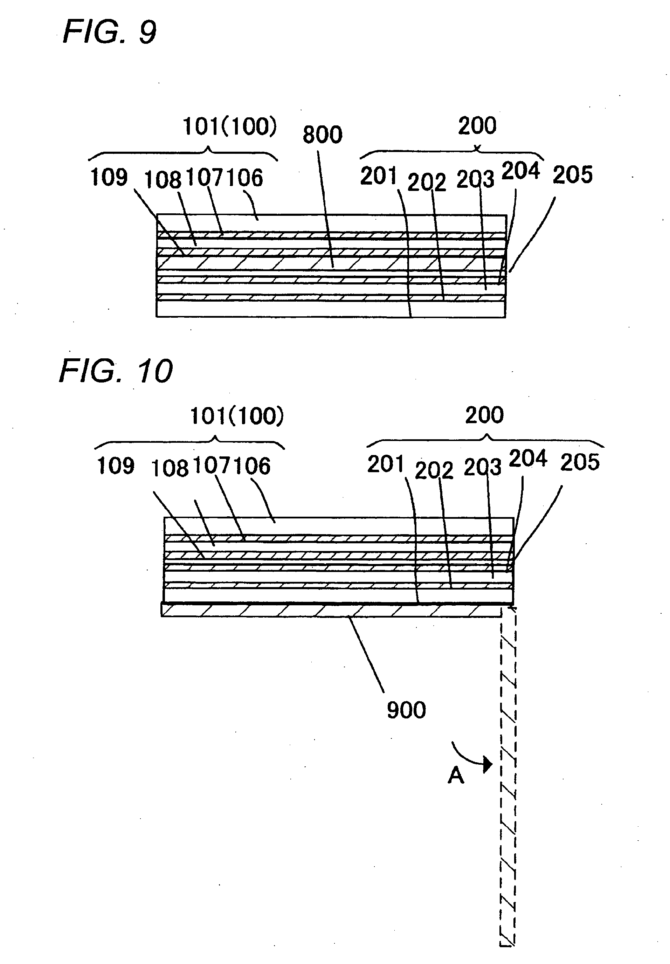

The above first embodiment is of a street light structure in which the illuminating apparatus 1 is fitted to the pole 2. However, as illustrated in FIG. 8, the illuminating apparatus may be configured as a top light in a roof light window for lighting. In this case, as illustrated in a cross-sectional illustrative view of FIG. 9, a reflective plate 800 is detachably inserted between the surface-emitting module 100 and the solar cell 200. The reflective plate 800 is attached or detached according to the detection by the luminance sensor fitted onto the frame part 102 surrounding the light emitting unit 101 so that the light blocking state and the light transmitting state can be created as in the above first embodiment.

The other parts are identical with those in the above first embodiment, and therefore their description will be omitted. For example, both of the solar cell 200 and the surface-emitting module 100 are formed in the same manner as the apparatus structure described with reference to FIG. 7.

Also, the operation is also identical with that in the first embodiment.

The self-emitting illuminating apparatus that is switchable by the illumination sensor may be configured. Also, the reflective plate 800 can be detachably attached through a remote control in the same manner as open/close of a window. The control unit and the illumination sensor may be fitted onto a ceiling or a wall, separately.

Alternatively, the reflective plate 800 may be made of a material that is switchable between the translucency and the reflectivity according to the applied voltage such as the liquid crystal shutter panel described in the first embodiment. As a result, the switching operation can be controlled by not the mechanical attachment or detachment, but the application of voltage.

### (Third Embodiment)

Also, in the second embodiment, the reflective plate as the switching board is detachably inserted between the surface-emitting module 100 and the solar cell 200. Alternatively, a reflective surface may be formed on a back surface side of the solar cell. That is, as illustrated in FIG. 10, a switching board 900 such as an aluminum plate may be disposed on the back surface side of the solar cell 200. In this case, the switching board 900 can be opened and closed in a direction indicated by an arrow A by a hinge so as to switch between the translucency and the non-translucency.

In the above first and second embodiments, the solar cell and the electroluminescence element are bonded together through an adhesive or directly. Alternatively, the light-transmissive fourth electrode, the polycrystalline silicon layer, the light-transmissive third electrode, and the antireflective film are laminated on the support substrate to form the solar cell. Thereafter, liquid crystal is formed on an upper layer of the lamination, and an upper layer of the liquid crystal is sequentially coated with the light-transmissive second electrode, the light emitting function layer, and the light-transmissive first electrode. As a result, the solar cell, the liquid crystal shutter panel, and the electroluminescence element may be sequentially laminated on the same substrate to form a laminated structure.

That is, the solar cell and the electroluminescence element are integrated together to form the laminated structure. With this structure, the illuminating apparatus can be further thinned.

Also, in this embodiment, the organic electroluminescence element is used as the surface-emitting module. Alternatively, an inorganic electroluminescence element may be used.

### Description of Reference Signs

- 100: surface-emitting module
- 200: solar cell
- 300: liquid crystal shutter panel
- 400: storage battery
- 500: illumination sensor
- 600: control unit
- 800: reflective plate
- 900: reflective plate

## Claims

1. An illuminating apparatus (1) comprising:
a light-transmissive surface-emitting module (100); and
a switching board (300) that is disposed on a back surface of the surface-emitting module (100),
wherein the switching board (300) is configured such that a state of the switching board (300) can be switched between a light blocking state and a light transmitting state
**characterised by**
a solar cell (200) that is arranged on the back surface of the surface-emitting module (100) through the switching board (300),
wherein, in the light blocking state, a reflective light reflected by the switching board and a direct light emitted from the surface-emitting module (100) toward an irradiation direction are extracted only from a front surface of the surface-emitting module (100).

2. The illuminating apparatus (1) according to claim 1, wherein the switching board (300) comprises a liquid crystal shutter panel.

3. The illuminating apparatus (1) according to claim 1 or 2, further comprising:
an illumination sensor (500); and
a lighting control unit (600) configured to control lighting of the surface-emitting module (100) according to an output of the illumination sensor (500).

4. The illuminating apparatus (1) according to claim 3,
wherein the illumination sensor (500) is disposed in parallel to a frame part (102) that surrounds a light emitting unit (101) of the surface-emitting module (100) from a side,
wherein a storage battery (400) is disposed at a back side of the solar cell (200), and configured to accumulate an electromotive force generated by the solar cell (200), and
wherein the lighting control unit (600) controls the lighting of the surface-emitting module (100) with application of a voltage from the storage battery (400).

5. The illuminating apparatus (1) according to claim 1,
wherein the surface-emitting module (100) comprises an electroluminescence element in which a light-transmissive first electrode (107), a layer (108) having a light emitting function, and a light-transmissive second electrode (109) are sequentially laminated on a light-transmissive substrate (106).

## Patentansprüche

1. Beleuchtungsvorrichtung (1), die umfasst:
ein lichtdurchlässiges oberflächenemittierendes Modul (100);
eine Schaltplatine (300), die auf einer hinteren Oberfläche des oberflächenemittierenden Moduls (100) angeordnet ist,
wobei die Schaltplatine (300) derart konfiguriert ist, dass ein Zustand der Schaltplatine (300) zwischen einem lichtblockierenden Zustand und einem lichtdurchlässigen Zustand umgeschaltet werden kann,
**gekennzeichnet durch**
eine Solarzelle (200), die **durch** die Schaltplatine (300) auf der hinteren Oberfläche des oberflächenemittierenden Moduls (100) angeordnet ist,
wobei in dem lichtblockierenden Zustand ein reflektiertes Licht, das von der Schaltplatine reflektiert wird, und ein direktes Licht, das von dem oberflächenemittierenden Modul (100) in Richtung einer Strahlungsrichtung emittiert wird, nur von einer vorderen Oberfläche des oberflächenemittierenden Moduls (100) extrahiert werden.

2. Beleuchtungsvorrichtung (1) nach Anspruch 1, wobei die Schaltplatine (300) eine Flüssigkristallverschlussblende umfasst.

3. Beleuchtungsvorrichtung (1) nach Anspruch 1 oder 2, die ferner umfasst:
einen Beleuchtungssensor (500); und
eine Beleuchtungssteuereinheit (600), die konfiguriert ist, um die Beleuchtung des oberflächenemittierenden Moduls (100) gemäß einer Ausgabe des Beleuchtungssensors (500) zu steuern.

4. Beleuchtungsvorrichtung (1) nach Anspruch 3,
wobei der Beleuchtungssensor (500) parallel zu einem Rahmenteil (102) angeordnet ist, der eine lichtemittierende Einheit (101) des oberflächenemittierenden Moduls (100) von einer Seite umgibt,
wobei eine Speicherbatterie (400) auf einer Rückseite der Solarzelle (200) angeordnet ist und konfiguriert ist, um eine elektromotorische Kraft zu akkumulieren, die von der Solarzelle (200) erzeugt wird, und
wobei die Beleuchtungssteuereinheit (600) die Beleuchtung des oberflächenemittierenden Moduls (100) mit dem Anlegen einer Spannung von der Speicherbatterie (400) steuert.

5. Beleuchtungsvorrichtung (1) nach Anspruch 1,
wobei das oberflächenemittierende Modul (100) ein Elektrolumineszenzelement umfasst, in dem eine lichtdurchlässige erste Elektrode (107), eine Schicht (108) mit einer lichtemittierenden Funktion und eine lichtdurchlässige zweite Elektrode (109) nacheinander auf ein lichtdurchlässiges Substrat (106) laminiert sind.

## Revendications

1. Appareil d'éclairage (1) comprenant :
un module à émission superficielle transmetteur de lumière (100) ; et
un poste de commande (300) qui est disposé sur une surface arrière du module à émission superficielle (100),
dans lequel le poste de commande (300) est configuré de sorte qu'un état du poste de commande (300) peut être commuté entre un état de blocage de lumière et un état de transmission de lumière,
**caractérisé par**
une cellule solaire (200) qui est agencée sur la surface arrière du module à émission superficielle (100) à travers le poste de commande (300),
dans lequel, dans l'état de blocage de lumière, une lumière réfléchissante réfléchie par le poste de commande et une lumière directe émise depuis le module à émission superficielle (100) vers une direction de rayonnement sont extraites uniquement depuis une surface avant du module à émission superficielle (100).

2. Appareil d'éclairage (1) selon la revendication 1, dans lequel le poste de commande (300) comprend un panneau d'obturation à cristaux liquides.

3. Appareil d'éclairage (1) selon la revendication 1 ou 2, comprenant en outre :
un capteur d'éclairage (500) ; et
un module de commande d'éclairage (600) configuré pour commander l'éclairage du module à émission superficielle (100) en fonction d'une sortie du capteur d'éclairage (500).

4. Appareil d'éclairage (1) selon la revendication 3,
dans lequel le capteur d'éclairage (500) est disposé parallèlement à une partie de cadre (102) qui entoure un module d'émission de lumière (101) du module à émission superficielle (100) depuis un côté,
dans lequel une batterie rechargeable (400) est disposée au niveau d'un côté arrière de la cellule solaire (200) et configurée pour accumuler une force électromotrice générée par la cellule solaire (200), et
dans lequel le module de commande d'éclairage (600) commande l'éclairage du module à émission superficielle (100) avec l'application d'une tension provenant de la batterie rechargeable (400).

5. Appareil d'éclairage (1) selon la revendication 1,
dans lequel le module à émission superficielle (100) comprend un élément électroluminescent dans lequel une première électrode transmettrice de lumière (107), une couche (108) ayant une fonction d'émission de lumière et une seconde électrode transmettrice de lumière (109) sont appliquées en couche de manière séquentielle sur un substrat transmetteur de lumière (106).
